(19) Europäisches Patentamt
European Patent Office
Office européen des brevets

(11) **EP 4 444 047 A1**

(12) **EUROPEAN PATENT APPLICATION**

(43) Date of publication:
**09.10.2024 Bulletin 2024/41**

(21) Application number: **24164724.7**

(22) Date of filing: **20.03.2024**

(51) International Patent Classification (IPC):
**H05K 1/02** (2006.01)   **H05K 1/11** (2006.01)
**H05K 3/42** (2006.01)   **H05K 3/00** (2006.01)

(52) Cooperative Patent Classification (CPC):
**H05K 1/0298; H05K 1/115; H05K 3/421;**
H05K 3/002; H05K 3/0047; H05K 3/0055;
H05K 2201/09509; H05K 2201/09563;
H05K 2201/09618; H05K 2201/09854;
H05K 2201/2072; H05K 2203/0307;
H05K 2203/072; H05K 2203/0796; H05K 2203/1184

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **28.03.2023 CN 202310317763**

(71) Applicant: **AT&S (Chongqing) Company Limited
Chongqing 401133 (CN)**

(72) Inventors:
• **WANG, JyunMin
Chongqing 401133 (CN)**
• **FUNG, James
Chongqing 401133 (CN)**

• **ZHOU, Brance
Chongqing 400030 (CN)**
• **LI, Stella
Chongqing 400042 (CN)**
• **WEI, Vivi
Chongqing 401120 (CN)**
• **DUAN, Cain
Chongqing 401133 (CN)**
• **XIE, Melody
Chongqing 401133 (CN)**
• **ZHOU, Lucas
Chongqing 401133 (CN)**

(74) Representative: **Dilg, Haeusler, Schindelmann
Patentanwaltsgesellschaft mbH
Leonrodstraße 58
80636 München (DE)**

(54) **COMPONENT CARRIER AND METHOD OF MANUFACTURING THE SAME**

(57)   The present application provides a component carrier and a method of manufacture the same, the component carrier, comprising: a stack with a plurality of electrically insulating layer structures and one or more electrically conductive layer structures ,
the one or more electrically conductive layer structures comprise two opposed conductive surfaces ;
a plurality of first vias , formed at a front side of the stack , the plurality of first vias is connected to one of the two opposed conductive surfaces through a respective first baseline etch surface ; and

a plurality of second vias , formed at a back side of the stack, the front side is opposed to the back side , wherein the plurality of second vias is connected to the other one of the two opposed conductive surfaces through a respective second baseline etch surface .

The total area defined by the first baseline etch surfaces is higher than the total area defined by the second baseline etch surfaces and the depth of at least one of the first baseline etch surfaces is lower than the depth of at least one of the second baseline etch surfaces.

Fig. 1

EP 4 444 047 A1

**Description**

Field of the Invention

1. The invention relates to a component carrier with a stack and a first plurality of vias on a front side of the stack and a second plurality of vias on a back side of the stack, wherein the vias are connected to respective opposed conductive surfaces through baseline etch surfaces. Further, the invention relates to a method of manufacturing the component carrier.

2. Accordingly, the invention may relate to the technical field of component carriers such as printed circuit boards or IC substrates, in particular in the context of manufacturing vias.

Technical Background

3. In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

4. In particular, manufacturing robust and reliable electrically conductive vertical through-connections (vias) in a component carrier layer stack may be considered a challenge. In case that defects such as e.g. residues, voids, or cracks are formed during the via formation process, the reliability/robustness of the via may be significantly reduced.

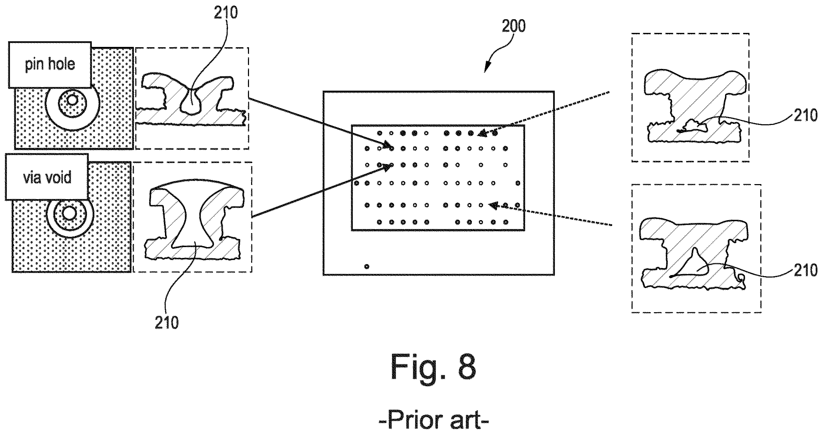

5. **Figure 8** shows an example of a conventional circuit board 200 in planar view. Some of the vias are enlarged and shown in a cross section. It can be seen that each of the vias comprises a defect 210. Each via is connected at its lower extremity to a metal layer. During a cleaning process of the hole (for the via formation by filling) and the metal layer at the hole bottom, a baseline etch region within the surface of the metal layer can form. The via is then manufactured by filling the hole with conductive material onto the baseline etch region.

6. However, the baseline etch region at the interface between via and metal layer can cause the formation of a plurality of defects. The via on the top of the left side in Figure 8 comprises a so-called pin-hole void, i.e. a drop-like void, wherein the bottom of the drop is the baseline etch. The via on the bottom left side comprises a large void. These defects may be in particular obtained, when a high etch down (baseline etch region with high depth) happens. Such a defect may be optically detectable using e.g. an AOI instrument. The vias on the right side of Figure 8 are closed at the top, yet comprise voids as well around the baseline etch. In this case, there are void defects as well, however, these cannot be detected by an AOI instrument, since the vias are closed at the top. The reliability may be especially low in the later case.

7. On the one hand, it may be concluded that the baseline etch region could be undesired since it may be the cause of void and crack formation. On the other hand, however, the baseline etch may be an unavoidable result of the etching step, which may be necessary in order to remove undesired residues before via filling.

Summary of the Invention

8. There may be a need to provide reliable and robust via structures for a component carrier. A component carrier and a manufacture method are provided.

9. According to an aspect of the invention, there is described a component carrier (e.g. a printed circuit board or an IC substrate), comprising:

i) a (multi-layer) stack with a plurality of electrically insulating layer structures and one or more (in particular at least two) electrically conductive layer structures (preferably a copper layer structure, more preferable a thin copper layer with a thickness of the range between 5 $\mu$m and 20 $\mu$m). Hereby, the one or more electrically conductive layer structure(s) comprise(s) two opposed conductive surfaces (preferably the at least one electrically conductive layer structure comprises at least two electrically conductive layer structures oppositely provided with respect to at least one electrically insulating layer structure),

ii) a plurality of first vias, formed at a front side of the stack, wherein the plurality of first vias is connected to one of the two opposed conductive surfaces (in particular to a first electrically conductive layer structure) through a respective first baseline etch surface, and

iii) a plurality of second vias, formed at a back side of the stack, wherein the front side is opposed to the back side, wherein the plurality of second vias is connected to the other one of the two opposed conductive surfaces (in particular to a second electrically conductive layer structure) through a respective second baseline etch surface.

10. Hereby, the total area defined by the first baseline etch surfaces is higher than the total area defined by the second baseline etch surfaces, and the depth (in vertical direction z, being the stack thickness direction) of at least one (in particular the majority, more in particular at least 80%, more in particular all) of the first baseline etch surfaces is lower than the depth of at least one of the second baseline etch surfaces.

11. According to a further aspect of the invention, there is described a method of manufacturing a component carrier, the method comprising:

i) forming a stack with a plurality of electrically insulating layer structures and one or more (in particular at least two) electrically conductive layer structures, wherein the one or more electrically conductive layer structures comprise two opposed conductive surfaces,

ii) forming a plurality of first openings in one of the plurality of electrically insulating layer structures at a front side of the stack, thereby exposing the conductive surface of one (in particular a first) of the electrically conductive layer structures,

iii) forming a plurality of second openings in another one of the plurality of electrically insulating layer structures at a back side of the stack, wherein the front side is opposed to the back side, thereby exposing the opposed conductive surface (with respect to the conductive surface) of one (in particular a second) of the electrically conductive layer structures.

12. The total area of one (first) of the electrically conductive layer structures (in particular the conductive surface) exposed at the front side is higher than the total area of one (second) of the electrically conductive layer structures (in particular the opposed conductive surface) exposed at the back side.

13. iv) The method further comprising: contemporaneously etching the front side and the back side, thereby forming in the exposed conductive surface respective first baseline etch surfaces (in particular in the majority, more in particular in at least 80%, more in particular in each of the exposed conductive surface) and in the exposed opposed conductive surfaces respective second baseline etch surfaces (in particular in the majority, more in particular in at least 80%, more in particular in each of the exposed conductive surface).

14. In the context of the present document, the term "baseline etch surface" (or baseline etch structure/region/portion) may in particular relate to a surface within a conductive surface of an electrically conductive layer structure. In particular, such a baseline etch surface is formed when said conductive surface is made subject of an etching step. The etching may hereby specifically serve the purpose of removing undesired material such as residues from the conductive surface and/or enlarging the surface of the conductive surface. The term "baseline etch surface" may further refer to a concave surface partially extending in the electrically conductive layer structure. Preferably, the "baseline etch surface" may be located on an exposed surface region of the electrically conductive layer structure of a (semi-) finished product. In a preferred example, an electrically insulating layer structure is arranged on the conductive surface (of the electrically conductive layer structure) and an opening is present through said electrically insulating layer structure down to the baseline etch surface in order to expose the conductive surface. When the opening is filled with electrically conductive material to thereby form a via, the via may then be electrically/physically (directly) connected to the baseline etch surface.

15. In the context of the present document, the term "conductive surface" may in particular refer to a surface that is electrically conductive, e.g. the surface of an electrically conductive layer structure such as a copper layer. The term "opposed conductive surfaces" may refer to at least two conductive surfaces arranged opposite to each other, for example a first conductive surface on a front side of an electrically conductive layer structure and a second conductive surface on a back side (being opposed to the front side) of the electrically conductive layer structure. In an example with two or more electrically conductive layer structure (in a layer stack), the conductive surface may be an upper surface of an electrically conductive layer structure in an upper region of the stack, while the opposed conductive surface may be a lower surface of another electrically conductive layer structure in a lower region of the stack.

16. In the context of the present document, the term "total area" may in particular refer to the sum of areas of first baseline etch surfaces at the front side or the sum of areas of second baseline etch surfaces at the back side. In an example, the total area is determined from a planar view onto the front side or the back side, respectively.

17. In the context of the present document, the term "main surface" may particularly denote one of two largest opposing surfaces of a device. The main surfaces may be connected by circumferential side walls. The thickness of a device, such as a stack, may be defined by the distance between the two opposing main surfaces.

18. In the context of the present document, the term "component carrier" may particularly denote any support structure which is capable of accommodating one or more components thereon and/or therein for providing mechanical support and/or electrical connectivity. In other words, a component carrier may be configured as a mechanical and/or electronic carrier for components. In particular, a component carrier may be one of a printed circuit board, an organic interposer, a metal core substrate, an inorganic substrate, an IC (integrated circuit) substrate, a mounting base.

19. The term "component carrier preform" (or semi-finished product) may refer to a component carrier under manufacture, i.e. a component carrier that has not yet been completely finished. In a specific example, a component carrier preform may comprise openings to be filled with electrically conductive material (to thereby form vias), wherein baseline etch surfaces are exposed at the bottom of the openings. In a corresponding component carrier, in this example, the openings may be filled with the electrically conductive material to form the vias, which vias may then be connected to the baseline etch surfaces.

20. In the context of the present document, the term "IC substrate" may particularly denote a small component carrier. An IC substrate may be a, in relation to a PCB, comparably small component carrier onto which one or more components may be mounted and that may act as a connection medium between one or more chip(s) and a further PCB. More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. In an example, an IC substrate may be seen as an interposer, for example between electronic components and a printed circuit board.

21. In the present context, an IC substrate should not be understood as any substrate suitable to bear an IC. Instead, the term "IC substrate" may be a technically established term for a specific, high density PCB that comprises common PCB materials.

22. According to an exemplary embodiment, the invention may be based on the idea that robust and reliable via structures for a component carrier can be provided, when the total area defined by first baseline etch surfaces at a first component carrier surface is higher than the total area defined by second baseline etch surfaces at the second, opposed component carrier surface, and when the depth of at least one of the first baseline etch surfaces is lower than the depth of at least one of the second baseline etch surfaces.

23. In other words, the baseline etch surfaces at the front side and at the back side of the component carrier are formed such that the baseline etch surfaces at the first surface occupy a larger area (in particular there are more of them) and are less deep than the baseline etch surfaces at the opposed second surface.

24. Conventionally, there is a conflict in the via manufacture process, because an etching step before via formation may be necessary to remove undesired residues, however, said etching step causes a baseline etch, which in turn may be the cause of defects such as voids in the final via. Hence, a balance has to be found between avoiding residues (use etching step and form baseline etch) and avoiding voids (no etching step and hence no baseline etch (to remove metal (oxide) residues)).

25. It has now been surprisingly found by the Inventors that the reliability and robustness of via formation may be increased, when a manufacture process is chosen that is focused on a significantly different baseline etch surface architecture at the opposed component carrier main surfaces, i.e. i) more and less deep baseline etch surface on the one main surface and ii) lesser and deeper baseline etch surfaces on the other, opposed, main surface. Without wishing to be bound to a specific theory, it is presently believed that in this manner the etching, i.e. in an etching tank, may be better controllable for the two opposed main surfaces of the component carrier. Thus, by providing a higher number of openings, the depth of the baseline etch may become less deep than in case of a lower number of openings (in particular, when same hole diameter is considered for front and back side, i.e. total area of one side; in other words: the hole size does not need to be considered, when overall exposed region area size is considered).

26. In an example, the architecture of the component carrier may be chosen such that the first vias (at the front side) may require a higher degree of reliability than the second vias (at the back side). Since the first baseline etch surfaces comprise a lower depths, the corresponding first vias may be formed in a more reliable manner than the second vias.

Exemplary Embodiments

27. According to an embodiment, the amount of the first vias is higher than the amount of the second vias. This may provide the advantage that not only the total area but also the number of first vias is larger in comparison to the second vias. Thereby, the above described advantageous effects of the present architecture are further pronounced. According to an embodiment, the amount of the first vias is at least 1.3 times, in particular at least two times, more in particular at least four times, more in particular at least five times, higher than the amount of the second vias.

28. According to a further embodiment, the first baseline etch surfaces and/or the second baseline etch surfaces have a depth (along the vertical direction, in the stacking direction) in the ratio between 1% to 25%, in particular 2% to 20%, in particular between 2% to 15%, in particular between 4% and 15%, of the height (along the component carrier stacking direction) of the respective via (the first/second via connected to the respective first/second baseline etch surface). In other words, the depth baseline etch surface is low (not too large) in comparison with the corresponding via height. This may provide the advantage that defects caused by the baseline etch surface may be even further reduced.

29. According to a further embodiment, the first baseline etch surfaces and/or the second baseline etch surfaces comprise a depth of at least 0.5 μm, in particular at least 1 μm, in particular at least 2 μm. Such baseline etch surfaces may be relicts from an etching step to remove undesired materials/residues. Hence, the presence of such baseline etch surfaces may be seen as a quality criterion with respect to vias of the component carrier (preform), since surfaces (in particular of the opening into which the via should be formed) have been (intensively) cleaned.

30. According to a further embodiment, at least one first baseline etch surface and/or the first baseline etch surfaces comprise(s) a depth in the range 0.5 μm to 5 μm. This may provide the advantage that the first baseline etch surface comprises a significantly low depth, thereby eventually highly increasing the reliability and robustness of the corresponding via (by avoiding formation of defects such as voids).

31. According to a further embodiment, at least one second baseline etch surface and/or the second baseline etch surfaces comprise(s) a depth of at least 5 μm, in particular at least 8 μm. Even though the depth of the second baseline etch surface is larger than the depth of the first second baseline etch surface, the second baseline etch surface may still comprise a comparably low depth, thereby eventually increasing the reliability and robustness of the corresponding via.

32. According to a further embodiment, the first baseline etch surfaces and/or the second baseline etch surfaces comprise (at the bottom) a rough surface. This structural feature may reflect an etching step performed during the manufacture process. This may bring the advantage of ensuring reliable connection of electrically conductive material, in particular copper, to the first baseline etch surfaces and/or the second baseline etch surfaces.

33. According to a further embodiment, the connection between the extremity of at least one first via and the respective first baseline etch surface and/or the connection between the extremity of at least one second via and the respective second baseline etch surface is free of residues. This may provide the advantage that the quality of the via (in particular reliability and robustness) may be improved, since residues have been removed, e.g. by an etching step.

34. In this context, the term "residue" may in particular refer to a material that is undesired for the via formation. Further, the term "residue" may in particular refer to a material that is different from the material of the via (in particular conductive metal such as copper). In one example, the residue may comprise a metal salt, e.g. copper oxide. In another example, the residue may comprise organic material.

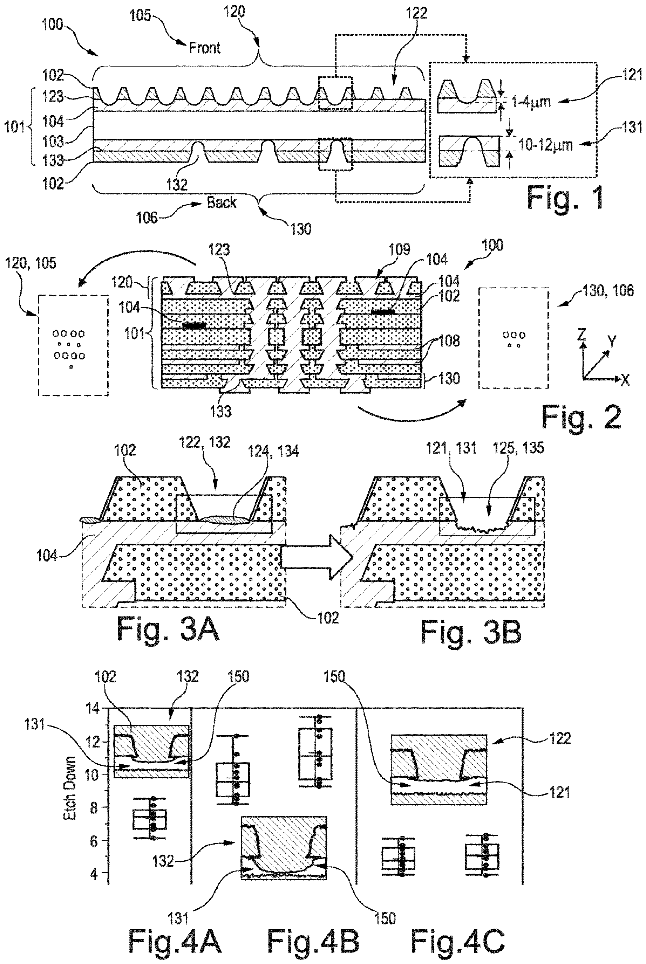

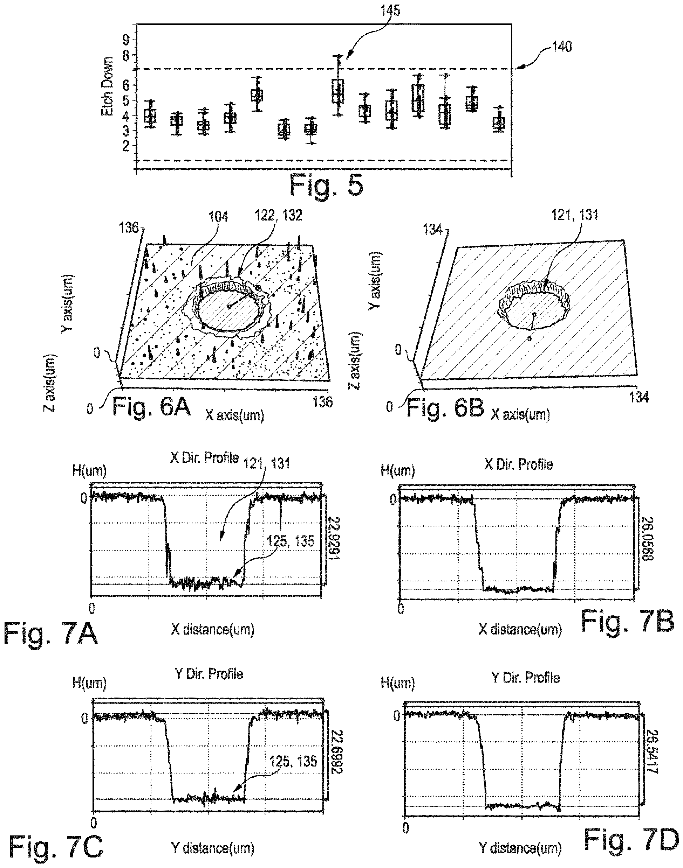

35. According to a further embodiment, at least one first via exposed extremity (via top and/or bottom) of the plurality of first vias and/or at least one second via exposed extremity (via top and/or bottom) of the plurality of second vias comprises a smooth surface. This may provide the advantage that the via is more robust and reliable. An exemplary example is shown in Figure 4 and Figure 7.

36. In the context of the present document, the term "surface roughness" may in particular refer to a property of a conductive (metal) surface. The surface roughness may be seen as a relative term, for example the roughness of a first surface is high in comparison to the surface roughness of a second surface with a lower roughness. In a further example, surface roughness may be seen as an absolute term, e.g. given as Ra. In a specific example, a rough surface may comprise a surface roughness Ra of more than 500 nm, in particular more than 700 nm. In a further specific example, the smooth surface may comprise a surface roughness Ra of less than 500 nm, in particular less than 300 nm, more in particular less than 100 nm.

37. The "roughness" of a surface quantifies the extent to which the surface deviates from its ideal form. Any deviations are usually analyzed in direction of the normal vector of the surface and are characterized by an amplitude, i.e. the height or length of the deviations in surface normal direction, and by a frequency, denoting the amount or number of deviations per surface area. Surface roughness correlates with friction between interacting rough surfaces, if they are moved relative to each other.

38. One of the most common roughness parameters is Ra, which may be the arithmetic average of the absolute values of surface deviations from a mean surface profile. The unit of the roughness parameter Ra is length and it is typically measured in micrometers or nanometers. The mean surface profile may be filtered from the raw surface profile, i.e. the measured surface profile, e.g. by eliminating a waviness component of surface deviations. Roughness Ra may thus be calculated as

$$Ra = \sum_{m=1,\dots,M} \sum_{n=1,\dots,N} |z(x_m, y_n) - \langle z \rangle| / MN$$

with

$$<z> \; = \; \textstyle\sum_{m=1,\ldots,M} \sum_{n=1,\ldots,N} z(x_m, y_n) \; / \; MN.$$

Here, the sampling points $(x_m, y_n)$ are equally spaced in directions x and y, which span the plane of the examined surface, and z is the direction normal to the examined surface. Thus, $z(x_m, y_n)$ denotes the surface deviation from the mean surface profile in direction of the surface normal at sampling point $(x_m, y_n)$. M and N determine the evaluation length in x-direction and in y-direction, respectively.

39. According to a further embodiment, the plurality of first vias and/or the plurality of second vias is essentially free of voids and/or cracks. This may provide the advantage that the via is more robust and reliable. Examples of deficiencies such as voids/cracks are shown in Figure 8. As described above, the architecture of the present component carrier may surprisingly improve the quality of the vias even though the etching step leading to the baseline etch surfaces is applied. In an example, cracks may be formed between the electrically conductive layer structure and the connected via (delamination effect)

40. The voids could also "bubbles" (closed/opened microchamber) between the electrically conductive layer structure and the connected via.

41. According to a further embodiment, the first plurality of vias and/or the second plurality of vias are located at an exposed (with respect to the component carrier main surface) respective electrically conductive layer structure of the stack. This may bring the advantage of connecting the plurality of first vias and/or the plurality of second vias with a further component carrier and/or a component.

42. According to a further embodiment, at least one respective electrically conductive layer structure is arranged between the exposed respective electrically conductive layer structure and a center of the stack (e.g. a central layer structure such as a core) in the stack thickness direction. In other words, a via may vertically interconnect at least two electrically conductive layer structures in the layer stack. Hereby, one layer structure may be exposed at a stack/component carrier main surface and directly electrically connectable, e.g. to a pad of an electronic component. In an example, the exposed electrically conductive layer structure may comprise a plurality of electric connection pads/terminals.

43. According to a further embodiment, the exposed respective electrically conductive layer structure and the respective electrically conductive layer structure are adjacent layers (in other words stacked upon each other, in particular with electrically insulating material in between) regarding the stack thickness direction.

44. This may provide the advantage that the especially reliable vias can provide efficient electrical connections through at least part of the component carrier.

45. According to a further embodiment, the first baseline etch surface and/or the second etch baseline surface comprises an under-etch portion or anchor structure. Such an under-etch portion may reflect the manufacture step of performing the etching. Hence, the under-etch portion may be seen as a quality criterion, because it proves that an intensive cleaning of the surface has been performed. Examples of under-etch portions for different baseline etch surfaces are shown in Figure 4. The term "anchor structure" may in particular refer to the circumstance that formed vias may have a host (free space/region) below the electrically insulating structure. This may enhance the structural integrity of the vias.

46. According to a further embodiment, the under-etch portion extends beyond the via diameter (in the via main extension direction). According to a further embodiment, the thickness between the under-etch portion and the electrically insulating layer structure on top is in the range 0.5 $\mu$m to 2 $\mu$m. A small under-etch portion may reflect a low depth of the baseline etch surface, which in turn may improve reliable via formation.

47. According to a further embodiment of the method, the contemporaneous etching comprises: immersing the component carrier in a bath containing an etching device. Accordingly, the etching may be performed in a straightforward manner, using established printed circuit board technology. An etching process may comprise for example using a tank with an etching liquid. The component carrier may be immersed (for example in an etching device such as a basket with other component carriers) into the etching liquid to perform the etching step, thereby removing residues and eventually forming the baseline etch surfaces.

48. In an example, the etching may be a soft-etching using an etching liquid. The etching liquid may comprise an oxidation agent or a plurality of oxidation agents for etching electrically conductive layer structures. The oxidation agent may comprise: inorganic and/or organic substances, e.g. nitric acid, sulfuric acid, aqua regia, hydrogen peroxide, persulfuric acid, peroxodisulfuric acid, peracetic acid, trifluoroperacetic acid and the corresponding salts thereof. Additionally and/or alternatively, the oxidation agent may comprise ferric chloride, or copper chloride. Furthermore, alkaline oxidation agents may be constituent of an etching liquid.

49. According to a further embodiment of the method, etching comprises: monitoring of the baseline etch surfaces depth based on an etch criterion. This may provide the advantage that a low baseline etch surface depth may be achieved in an efficient and reliable manner. For example, the component carrier (preform) may be moved out of the etching liquid (preferably several times), so that the baseline etch surface depth may be analyzed. Depending on the monitoring result, the component carrier may be immersed again into the etching liquid or be considered as comprising an acceptable baseline etch surface depth.

50. In this context, the term "etch criterion" may be understood as a quality criterion related to the etching process. For example, the etch criterion may refer to the depth of the baseline etch surface as outlined above. Nevertheless, other factors may be taken into account as well, when monitoring the (quality of) the etching process.

51. According to a further embodiment, the amount of the first openings is higher than the amount of the second openings, in particular the amount of the first openings is at least 1.3 times, in particular four times, higher than the amount of the second openings (see above).

52. According to a further embodiment, the first baseline etch surface and/or the second baseline etch surface comprises a concave shape. Such a concave shape of the baseline etch surfaces may be a relict from an etching step to remove undesired materials/residues. Thus, the concave shape of the baseline etching surfaces may enlarge the surface areas between the plurality of first vias and/or the plurality of second vias and the respective electrically conductive layer structure. This may bring the advantage, that the connection between the plurality of first vias and/or the plurality of second vias and the respective electrically conductive layer structure via the respective baseline etch surfaces have high reliability.

53. According to a further embodiment, the dimension (e.g. diameter, depth, etc.) of the plurality of the first via are comparable (in particular the same) as the dimension of the plurality of the second vias. Additionally and or alternatively, via dimensions may be different.

54. According to a further embodiment of the method, the etching comprises: cleaning the exposed conductive surface and/or the exposed opposed conductive surface, in particular to remove residues, more in particular metal oxides. This may provide the advantage that the via formation is more reliable since undesired residues, which may cause defects during via formation are removed.

55. According to a further embodiment, the method further comprising:

i) providing (e.g. by sputtering or another metallization method) a conductive material in the first openings and/or on the second openings (providing a conductive material in the corresponding openings and/or on the respective first/second baseline etch surface), thereby
ii) forming a plurality of first vias and a plurality of second vias, so that the plurality of first vias is connected to the conductive surface through the respective first baseline etch surfaces, and the plurality of second vias is connected to the opposed conductive surface through the respective second baseline etch surfaces.

56. This may provide the advantage that the vias on the baseline etch surfaces are formed in a straightforward manner, using reliable and establish printed circuit board technology. In particular, via filling may be done by plating, specifically copper plating.

57. In an embodiment, the component carrier is shaped as a plate. This contributes to the compact design, wherein the component carrier nevertheless provides a large basis for mounting components thereon. Furthermore, in particular a naked die as example for an embedded electronic component, can be conveniently embedded, thanks to its small thickness, into a thin plate such as a printed circuit board.

58. In an embodiment, the component carrier is configured as one of the group consisting of a printed circuit board, a substrate (in particular an IC substrate), and an interposer.

59. In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise for example resin and/or glass fibers, so-called prepreg or FR4 material, PID, or ABF. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

60. In the context of the present application, the term "substrate" may particularly denote a small component carrier. A substrate may be a, in relation to a PCB, comparably small component carrier onto which one or more components may be mounted and that may act as a connection medium between one or more chip(s) and a further PCB. For instance, a substrate may have substantially the same size as a component (in particular an electronic component) to be mounted thereon (for instance in case of a Chip Scale Package (CSP)). In another embodiment, the substrate may be substantially larger than the assigned component (for instance in a flip chip ball grid array, FCBGA, configuration). More specifically, a substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the substrate and can be used to provide electrical, thermal and/or mechanical connections of housed components or unhoused components (such as bare dies), particularly of IC chips, with a printed circuit board or intermediate printed circuit board. Thus, the term "substrate" also includes "IC substrates". A dielectric part of a substrate may be composed of resin with reinforcing particles (such as reinforcing spheres, in particular glass spheres).

61. The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

62. In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the component carrier as electrically insulating structures.

63. In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material or conductive polymers, such as graphene or poly(3,4-ethylenedioxythiophene) (PEDOT), respectively.

64. At least one further component may be embedded in and/or surface mounted on the stack. The component and/or the at least one further component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide ($Al_2O_3$) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide ($Ga_2O_3$), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

65. In an embodiment, the component carrier is a laminate-type component carrier. In such an embodiment, the component carrier is a compound of multiple layer structures which are stacked and connected together by applying a pressing force and/or heat.

66. After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

67. After having completed formation of a stack of electrically insulating layer structures and electrically conductive layer structures, it is possible to proceed with a surface treatment of the obtained layers structures or component carrier.

68. In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

69. It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable. A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless

Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Eletroless Palladium Autocatalytic Gold).

Brief Description of the Drawings

70. The aspects defined above and further aspects of the invention are apparent from the examples of embodiment to be described hereinafter and are explained with reference to these examples of embodiment.

71. Figure 1 shows a component carrier preform according to an exemplary embodiment of the invention.
72. Figure 2 shows a component carrier with a multi-layer stack according to an exemplary embodiment of the invention.
73. Figure 3A and 3B show removing a residue by etching according to an exemplary embodiment of the invention.
74. Figures 4A to 4C respectively show a different etching depth according to exemplary embodiments of the invention.
75. Figure 5 shows an etching criterion according to an exemplary embodiment of the invention.
76. Figures 6A and 6B respectively show an opening during the manufacture according to exemplary embodiments of the invention.
77. Figures 7A to 7D respectively show different baseline etching surfaces according to exemplary embodiments of the invention.
78. Figure 8 shows a conventional circuit board with vias that comprise defects.

Detailed Description of the Drawings

79. The illustrations in the drawings are schematic. In different drawings, similar or identical elements are provided with the same reference signs.

80. **Figure 1** shows a component carrier 100 according to an exemplary embodiment of the invention. The component carrier 100 comprises a stack 101 with an electrically insulating core layer structure 103, e.g. a fully cured resin such as FR4. Above and below the core layer structure 103, there are arranged respective electrically conductive layer structures 104. The upper electrically conductive layer structure 104 comprises a conductive surface 123, while the lower electrically conductive layer structure 104 comprises an opposed conductive surface 133 (the two conductive surfaces 123, 133 are opposed to each other). Hereby, the electrically conductive layer structures 104 can comprises a copper layer, e.g. a thin copper layer with a thickness of the range between 5 $\mu$m and 20 $\mu$m. The upper electrically conductive layer structure 104 and the lower electrically conductive layer structure 104 are opposed to each other and sandwich the electrically insulating core layer structure 103. In another embodiment (see e.g. Figure 2), a plurality of layer structures can be provided between the electrically conductive layer structures 104.

81. On top of the upper electrically conductive layer structure 104 (at the front side 105 of the stack 101) and below the lower electrically conductive layer structure 104 (at the back side 106 of the stack 101), there is respectively arranged an electrically insulating layer structure 102.

82. The component carrier 100 of Figure 1 is a semi-finished product (component carrier preform), where first vias 120 and second vias 130 (see Figure 2) have not yet been formed. A plurality of first openings 122 has been formed through the upper electrically insulating layer structure 102 at the front side 105 of the stack 101, thereby exposing the conductive surface of the upper electrically conductive layer structure 104. A plurality of second openings 132 has been formed in the lower electrically insulating layer structure 102 at the back side 106 of the stack 101, thereby exposing the opposed conductive surface of the lower electrically conductive layer structure 104.

83. It can be seen that the total area of the upper electrically conductive layer structure 104 exposed at the front side 105 is hereby higher than the total area of the lower electrically conductive layer structure 104 exposed at the back side 106. The amount of the first openings 122 is higher than the amount of the second openings 132, in this example at least four times higher than the amount of the second openings 132. The openings 122, 132 have been formed by a step of contemporaneously etching the front side 105 and the back side 106, thereby forming in (each of) the exposed conductive surfaces 123 respective first baseline etch surfaces 121 and in (each of) the exposed opposed conductive surfaces 133 respective second baseline etch surfaces 131. The baseline etch surfaces 121, 131 are shown in detail on the right side of Figure 1.

84. It can be seen that the total area defined by the first baseline etch surfaces 121 is higher than the total area defined by the second baseline etch surfaces 131 (in other words there are more of them) and the depth (in the vertical direction z) of the first baseline etch surfaces 121 (in this example in the range 1 to 4 $\mu$m) is lower than the depth of the second baseline etch surfaces 131 (in this example in the range 10 to 12 $\mu$m).

85. **Figure 2** shows a component carrier 100 with a multi-layer stack 101 according to an exemplary embodiment of the invention. In contrast to the example described for Figure 1, the component carrier 100 is a product and not a semi-finished product. In an example, the product of Figure 2 is manufactured from the semi-finished product of Figure 1. Further in contrast to Figure 1, the stack 101 comprises a plurality of electrically insulating layer structures 102 between the central layer structure 103 and the conductive surfaces 123, 133 of the electrically conductive layer structures 104. The electrically insulating layer structures 102 can further comprise electrically conductive layer structures 104 (in particular copper). A plurality of vias extend through the central layer structure 103 and said electrically insulating layer structures 102 to thereby electrically connect the front side 105 and the back side 106 of the stack 101.

86. In order to manufacture the openings 122, 132, mechanical drilling (results in essentially non-tapering shape) and/or laser drilling (e.g. $CO_2$/UV-laser) (results in tapering shape) may be used.

87. The component carrier 100 further comprises a plurality of first vias 120, formed at the front side 105 of the stack 101 (in the first openings 122), wherein said first vias 120 are connected to the upper conductive surface 123 through the first baseline etch surfaces 121, respectively. The component carrier 100 also comprises a plurality of second vias 130, formed at the back side 106 of the stack 101, wherein said second vias 130 are connected to the lower (opposed) conductive surface 133 through the second baseline etch surfaces 131, respectively.

88. The total area defined by the first baseline etch surfaces 121 is higher than the total area defined by the second baseline etch surfaces 131 and the depth of the first baseline etch surfaces 121 is lower than the depth of the second baseline etch surfaces 131. The amount of the first vias 120 is clearly higher than the amount of the second vias 130. The first baseline etch surface 121 and the second baseline etch surfaces 131 have a depth in the ratio between 2% to 20%, of the height of the respective via.

89. On the left side, there is shown a detailed planar view onto the front side 105, while on the right side, a detailed planar view onto the back side 106 is shown. Hereby, it can be clearly seen that the total area (and also the amount) of first vias 120 is significantly higher than the total area (and amount) of second vias 130. Hereby, the vias may have different (or equal) diameters on the same side (also on different sides of a redistribution layer structure).

90. The first vias 120 and the second vias 130 are located at (connected with an extremity to) an exposed respective electrically conductive layer structure 109 of the stack 101. An electrically conductive layer structure 104 is arranged between the exposed respective electrically conductive layer structure 109 and a center of the stack 101 (the central layer structure 103) in the stack thickness direction. The exposed respective electrically conductive layer structure 109 and the respective electrically conductive layer structure 104 are adjacent layers (on above the other) regarding stack thickness direction.

91. The final product of Figure 2 can further comprise a surface finish (not shown).

92. **Figure 3A and 3B** show removing a residue 124, 134 by etching according to an exemplary embodiment of the invention.

93. Figure 3A: a first opening 122 or a second opening 132 has been formed through an electrically insulating layer structure 102 down to a conductive surface of an electrically conductive layer structure 104. It can be seen a first residue 124 or a second residue 134 is situated on the bottom of the opening 122, 132 in direct contact with the electrically conductive layer structure 104. In order to remove such undesired residues 124, 134, a step of etching, e.g. a wet etching, is performed.

94. Figure 3B: after performing the etching step, the residue has been removed. However, due to the etching process, a part of the conductive surface has been removed, thereby forming a first etch surface 121 or a second etch surface 131. Due to the etching, the surface can be a first rough surface 125 or a second rough surface 135.

95. **Figures 4A to 4C** respectively show different etching depths according to exemplary embodiments of the invention.

96. Figure 4A: in this example, the depth of the baseline etch below the opening 132 is in the range 6 to 8.5 $\mu$m, thus rather corresponding to a second baseline etch surface 131 than to a first baseline etch surface 121. It can be seen in the detailed cross section that the etching step formed an under-etch portion 150 between the electrically insulating layer structure 102 and the conductive surface.

97. Figure 4B: in this example, the depth of the baseline etch below the opening 132 is in the range 8 to 13.5 $\mu$m, thereby clearly classifying as a second baseline etch surface 131. It can be seen in the detailed cross section that the etching step formed a large under-etch portion 150 between the electrically insulating layer structure 102 and the conductive surface.

98. Figure 4C: in this example, the depth of the baseline etch below the opening 122 is in the range 3.5 to 6 $\mu$m, thus rather corresponding to a first baseline etch surface 121 than to a second baseline etch surface 131. It can be seen in the detailed cross section that the etching step formed a small under-etch portion 150 between the electrically insulating layer structure 102 and the conductive surface.

99. **Figure 5** shows an etching criterion 140 according to an exemplary embodiment of the invention. In this example, the etch criterion 140 defines a depth of the baseline etch surface in the range 1 to 7 $\mu$m as passing the etch criterion 140, thereby guaranteeing a sufficient quality. Nevertheless, there can be seen an outlier 145 that does not fulfill the etch criterion 140 since the etch is too deep.

100. **Figures 6A and 6B** respectively show an opening during the manufacture according to exemplary embodiments of the invention.

101. Figure 6A (before baseline etch): an opening 122, 132 has been formed through an electrically insulating layer structure 102, wherein the electrically insulating layer structure 102 is still covered by an exposed electrically conductive layer structure 104.

102. Figure 6B (after baseline etch): during the etching step, residues (not shown) in the opening 122, 132 are removed, thereby providing a baseline etch surface 121, 131. Further, due to the etching, the exposed electrically conductive layer structure 104 is removed in this example.

103. **Figures 7A to 7D** respectively show schematic baseline etching surfaces 121, 131 according to exemplary embodiments of the invention.

7A: shows a via before baseline etch.
7B: shows the same via after baseline etch.
7C: shows a second via before baseline etch.
7D: shows the same second via after baseline etch.

Reference signs

100    Component carrier
101    Stack
102    Electrically insulating layer structure
103    Core layer structure
104    Electrically conductive layer structure
105    First surface

106    Second surface
108    Further electrically conductive layer structure
109    Exposed electrically conductive layer structure
120    First vias
121    First baseline etch surface
122    First opening
123    Conductive surface
124    First residue
125    First rough surface
130    Second vias
131    Second baseline etch surface
132    Second opening
133    Opposed conductive surface
134    Second residue
135    Second rough surface
140    Etch criterion
145    Out of etch criterion
150    Under-etch portion

200    Conventional circuit board
210    Void in via

**Claims**

1. A component carrier (100), comprising:

   a stack (101) with a plurality of electrically insulating layer structures (102) and one or more electrically conductive layer structures (104), wherein the one or more electrically conductive layer structures (104) comprise two opposed conductive surfaces ;
   a plurality of first vias (120), formed at a front side (105) of the stack (101), wherein said plurality of first vias (120) is connected to one of the two opposed conductive surfaces (123) through a respective first baseline etch surface (121); and
   a plurality of second vias (130), formed at a back side (106) of the stack (101), wherein the front side (105) is opposed to the back side (106), wherein said plurality of second vias (130) are connected to the other one of the two opposed conductive surfaces (133) through a respective second baseline etch surface (131);
   wherein the total area defined by the first baseline etch surfaces (121) is higher than the total area defined by the second baseline etch surfaces (131) and the depth of at least one of the first baseline etch surfaces (121) is lower than the depth of at least one of the second baseline etch surfaces (131).

2. The component carrier (100) according to claim 1,
   wherein the amount of the first vias (120) is higher than the amount of the second vias (130), in particular the amount of the first vias (120) is at least 1.3 times, in particular at least four times, higher than the amount of the second vias (130).

3. The component carrier (100) according to one of the claims 1 or 2, wherein the first baseline etch surface (121) and/or the second baseline etch surface (131) has a depth in the ratio between 2% to 20%, in particular between 4% and 15%, of the height of the respective one of the first vias (120) and/or the second vias (130).

4. The component carrier (100) according to any one of the preceding claims, wherein the first baseline etch surface (121) and/or the second baseline etch surface (131) comprises a depth of at least 0.5 $\mu$m, in particular at least 2 $\mu$m.

5. The component carrier (100) according to any one of the preceding claims, wherein the first baseline etch surface (121) comprises a depth in the range 0.5 $\mu$m to 5 $\mu$m; and/or
   wherein the second baseline etch surface (131) comprise a depth of at least 5 $\mu$m, in particular at least 8 $\mu$m.

6. The component carrier (100) according to any one of the preceding claims, wherein the connection between the extremity of at least one first via (120) and the respective first baseline etch surface (121) and/or the connection between the extremity of at least one second via (130) and the respective second baseline etch surface (131) is free of residues.

7. The component carrier (100) according to any one of the preceding claims, comprising at least one of the following features:

wherein at least one first via top of the plurality of first vias (120) and/or at least one second via top of the plurality of second vias (130) comprises a smooth surface;
wherein the plurality of first vias (120) and/or the plurality of second vias (130) is free of voids (210).

8. The component carrier (100) according to any one of the preceding claims, wherein the first plurality of vias (120) and/or the plurality of vias (130) are located at an exposed respective electrically conductive layer structure (109) of the stack (101),

wherein at least one respective electrically conductive layer structure (104) is arranged between the exposed respective electrically conductive layer structure (109) and a center of the stack (101) in the stack thickness direction ,
in particular wherein the exposed respective electrically conductive layer structure (109) and the respective electrically conductive layer structure (104) are adjacent layers regarding stack thickness direction .

9. The component carrier (100) according to any one of the preceding claims, wherein the first baseline etch surface (121) and/or the second etch baseline surface (131) comprises an under-etch portion (150) or anchor structure,

in particular wherein the under-etch portion (150) extends beyond the respective one of the first via and/or the second via diameter in the respective one main extension direction ,
more in particular wherein the thickness of the under-etch portion (150) is in the range 0.5 $\mu$m to 2 $\mu$m.

10. A method of manufacturing a component carrier (100), the method comprising:

forming a stack (101) with a plurality of electrically insulating layer structures (102) and one or more electrically conductive layer structures (104), wherein the one or more electrically conductive layer structures (104) comprise two opposed conductive surfaces;
forming a plurality of first openings (122) in one of the plurality of electrically insulating layer structures (102) at a front side (105) of the stack (101), thereby exposing the conductive surface (123) of one of the electrically conductive layer structures (104);
forming a plurality of second openings (132) in another one of the plurality of electrically insulating layer structures (102) at a back side (106) of the stack (101), wherein the front side (105) is opposed to the back side (106), thereby exposing the other opposed conductive surface (133) of one of the electrically conductive layer structures (104);
wherein the total area of one of the electrically conductive layer structures (104) exposed at the front side (105) is higher than the total area of one of the electrically conductive layer structures (104) exposed at the back side (106); the method further comprising:
contemporaneously etching the front side (105) and the back side (106), thereby forming in the exposed conductive surfaces (123) respective first baseline etch surfaces (121) and in the other exposed opposed conductive surfaces (133) respective second baseline etch surfaces (131).

11. The method according to claim 10, wherein the contemporaneous etching comprises:
immersing the component carrier (100) in a bath containing an etching device.

12. The method according to claim 10 or 11, wherein etching comprises:
monitoring of the depth of the first baseline etch surfaces and/or second baseline etch surfaces based on an etch criterion.

13. The method according to any one of claims 10 to 12,
wherein the amount of the first openings (122) is higher than the amount of the second openings (130), in particular the amount of the first openings (122) is at least 1.3 times, in particular four times, higher than the amount of the second openings (132).

14. The method according to any one of claims 10 to 13, wherein the etching comprises:
cleaning the exposed conductive surface and/or the exposed opposed conductive surface, in particular to remove residues (124, 134), more in particular metal oxides.

15. The method according to any one of claims 10 to 14, further comprising:

providing a conductive material in the first openings (122) and in the second openings (132), thereby forming a plurality of first vias (120) and a plurality of second vias (130), so that the plurality of first vias (120) is connected to the conductive surface through the respective first baseline etch surfaces (121), and the plurality of second vias (130) is connected to the opposed conductive surface through the respective second baseline etch surfaces (131).

Fig. 1

Fig. 2

Fig. 3A        Fig. 3B

Fig.4A      Fig.4B      Fig.4C

Fig. 5

Fig. 6A

Fig. 6B

Fig. 7A

Fig. 7B

Fig. 7C

Fig. 7D

pin hole

via void

210

200

210

210

210

210

**Fig. 8**

-Prior art-

**EP 4 444 047 A1**

Europäisches
Patentamt
European
Patent Office
Office européen
des brevets

**EUROPEAN SEARCH REPORT**

Application Number

EP 24 16 4724

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 890 456 A1 (AUSTRIA TECH & SYSTEM TECH [AT]) 6 October 2021 (2021-10-06) | 1-10, 12-15 | INV. H05K1/02 |
| A | * paragraphs [0043], [0069] - [0082]; figures 1a-g, 2c * | 11 | H05K1/11 H05K3/42 |
| | ----- | | |
| A | US 2018/279486 A1 (MATSUMOTO HIROSHI [JP]) 27 September 2018 (2018-09-27) * figures 1A-F * | 1-15 | ADD. H05K3/00 |
| | ----- | | |
| A | US 2009/288870 A1 (KONDO HITOSHI [JP] ET AL) 26 November 2009 (2009-11-26) * figures 1A-3B * | 1-15 | |
| | ----- | | |
| | | | TECHNICAL FIELDS SEARCHED (IPC) |
| | | | H05K |

The present search report has been drawn up for all claims

| Place of search | Date of completion of the search | Examiner |
|---|---|---|
| The Hague | 20 August 2024 | Engel, Lukas |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 24 16 4724

This annex lists the patent family members relating to the patent documents cited in the above-mentioned European search report.
The members are as contained in the European Patent Office EDP file on
The European Patent Office is in no way liable for these particulars which are merely given for the purpose of information.

20-08-2024

| Patent document cited in search report | | Publication date | Patent family member(s) | | Publication date |
|---|---|---|---|---|---|
| EP 3890456 | A1 | 06-10-2021 | NONE | | |
| US 2018279486 | A1 | 27-09-2018 | CN | 108353510 A | 31-07-2018 |
| | | | EP | 3386282 A1 | 10-10-2018 |
| | | | JP | 6819608 B2 | 27-01-2021 |
| | | | JP | WO2017094470 A1 | 13-09-2018 |
| | | | US | 2018279486 A1 | 27-09-2018 |
| | | | US | 2020337156 A1 | 22-10-2020 |
| | | | WO | 2017094470 A1 | 08-06-2017 |
| US 2009288870 | A1 | 26-11-2009 | JP | 5322531 B2 | 23-10-2013 |
| | | | JP | 2010010639 A | 14-01-2010 |
| | | | US | 2009288870 A1 | 26-11-2009 |

EPO FORM P0459

For more details about this annex : see Official Journal of the European Patent Office, No. 12/82